**Europäisches Patentamt**

**European Patent Office**

**Office européen des brevets**

(19)

(11) Veröffentlichungsnummer: **0 025 168
B1**

(12) **EUROPÄISCHE PATENTSCHRIFT**

(45) Veröffentlichungstag der Patentschrift:
03.06.87

(51) Int. Cl.⁴: **H 01 L 27/14, H 04 N 3/14**

(21) Anmeldenummer: **80105057.6**

(22) Anmeldetag: **26.08.80**

(54) **Monolithisch integrierte Schaltung mit einem zweidimensionalen Bildsensor.**

(30) Priorität: **11.09.79 DE 2936703**

(43) Veröffentlichungstag der Anmeldung:
**18.03.81 Patentblatt 81/11**

(45) Bekanntmachung des Hinweises auf die Patenterteilung:
**03.06.87 Patentblatt 87/23**

(84) Benannte Vertragsstaaten:
**BE FR GB IT NL**

(56) Entgegenhaltungen:
**DE - A - 2 642 166
FR - A - 2 344 928
US - A - 3 806 729
US - A - 3 845 295**

**IEEE JOURNAL OF SOLID STATE CIRCUITS, Band
SC-14, Nr. 3, Juni 1979, Seiten 604-608, New York, USA
R. KOCH: "Charge-injection device with CCD readout"**

(73) Patentinhaber: **Siemens Aktiengesellschaft Berlin und
München, Wittelsbacherplatz 2, D-8000 München 2 (DE)**

(72) Erfinder: **Koch, Rudolf, Dipl.-Ing., Nimrodstrasse 42,
D-8034 Germering (DE)**

**Beschreibung**

Die Erfindung bezieht sich auf eine integrierte Schaltung mit einem zweidimensionalen Bildsensor nach dem Oberbegriff des Anspruchs 1 und auf Verfahren zu ihrem Betrieb.

Eine Schaltung dieser Art ist aus der DE-OS 2 642 166 (76 P 7124) in Verbindung mit der DE-PS 2 611 771 bekannt. Der DE-OS ist entnehmbar, dass bei einer zu kurz bemessenen Zeitspanne für die Auslesung der Sensorsignale über die Spaltenleitungen und über ein Barriere-Element (Schwellwertelement) in die Stufen eines Schieberegisters unvollständige Ladungsübertragungen auftreten können, wobei die zurückbleibenden Ladungen die folgenden Ladungsübertragungen beim Auslesen der nächsten Zeilen des Bildsensors beeinflussen. Dies ist insbesondere dann der Fall, wenn z.B. entsprechend den Zeitbedingungen einer Fernsehnorm für die Abtastung und Auslesung einer Bildzeile lediglich 64 µs zur Verfügung stehen, von denen 12 µs in die Austastlücke zwischen zwei Zeilensignalen fallen. In diesen 12 µs müsste die parallele Übertragung der Signale einer Sensorzeile über das Barriere-Element in das Schieberegister erfolgen.

Um die Auslesung zu beschleunigen, wird nun bei der Schaltung nach der DE-OS 2 642 166 zwischen dem Barriere-Element und jeder Stufe des Schieberegisters, in die ein Sensorsignal eingelesen wird, ein Speicherkondensator eingefügt, der über ein Transfergate mit dem Eingang der Schieberegisterstufe verbunden ist. Andererseits ist der DE-PS 2 611 771 eine Schaltung mit einem zweidimensionalen Bildsensor entnehmbar, bei der zwei Schieberegister nebeneinander angeordnet sind und bei der ein erster Auslesevorgang über die Spaltenleitungen zum Auslesen der von Störsignalen beeinflussten Sensorsignale in das erste Schieberegister erfolgt, an den sich ein zweiter Auslesevorgang zum Auslesen der Nullsignale, d.h. der Störsignale allein, anschliesst. Die Nullsignale werden auf die Stufen des zweiten Schieberegisters übertragen. Am Ausgang beider Schieberegister befindet sich eine differenzbildende Stufe, die aus zwei über dieselbe Spaltenleitung abgeleiteten Signalen ein von den Störungen befreites Sensorsignal ableitet.

Aus der US-A 3 806 729 ist ein zweidimensionaler Bildsensor bekannt, der eine Reihe von nebeneinanderliegenden CCD-Anordnungen aufweist. Dabei dienen jeweils die ersten, dritten usw. CCD-Elemente zur Aufnahme von optisch erzeugten Ladungsmengen, während die zweiten, vierten usw. CCD-Elemente optisch inaktiv sind. Nachdem durch eine Belichtung der optisch aktiven Elemente mit einer Szene in diesen Elementen Signalladungen erzeugt worden sind, werden diese in die jeweils benachbarten, optisch inaktiven Elemente verschoben. Hierauf folgt eine weitere Belichtung der ersten, dritten usw. Elemente, jedoch mit einem neutralen Hintergrund anstelle der aufzunehmenden Szene. Dabei entstehen «Hintergrund»-Ladungen, die dann zusammen mit den Signalladungen auf eine differenzbildende Stufe ausgelesen werden.

Der Erfindung liegt die Aufgabe zugrunde, eine der DE-PS 2 611 771 entsprechende, doppelte Auslesung einer Sensorzeile in einer so kurzen Zeitspanne durchzuführen, wie sie mit der Schaltung nach der DE-OS 2 642 166 für eine einfache Auslesung erreicht werden kann. Diese Aufgabe wird gemäss der Erfindung durch die im Anspruch 1 gekennzeichneten Merkmale gelöst. Gemäss weiterer Erfindung wird diese Aufgabe auch durch die im Anspruch 2 bzw. im Anspruch 3 gekennzeichneten Merkmale gelöst.

Der mit der Erfindung erzielbare Vorteil besteht insbesondere darin, dass die durch die doppelte Auslesung erreichbare Störbefreiung trotz eines bei sonst gleichen Bedingungen etwa verdoppelten Zeitaufwandes gegenüber der einfachen Auslesung nunmehr auch bei einem schnellen Ausleseverfahren gemäss der DE-OS 2 642 166 zur Verfügung steht.

Die Erfindung wird nachfolgend anhand der Zeichnung näher erläutert. Dabei zeigt:

Fig. 1 eine schematische Darstellung eines ersten Ausführungsbeispiels der Erfindung,

Fig. 2 eine Schnittdarstellung einer Teilschaltung von Fig. 1,

Fig. 3 Spannungs-Zeit-Diagramme zur Erläuterung der Schaltungen nach den Figuren 1 und 2,

Fig. 4 eine erste Alternative zu der in Fig. 2 dargestellten Teilschaltung,

Fig. 5 Spannungs-Zeit-Diagramme zur Erläuterung von Fig. 4,

Fig. 6 eine zweite Alternative zu der Teilschaltung nach Fig. 2,

Fig. 7 Spannungs-Zeit-Diagramme zur Erläuterung von Fig. 6 und

Fig. 8 eine dritte Alternative zu der Teilschaltung nach Fig. 2.

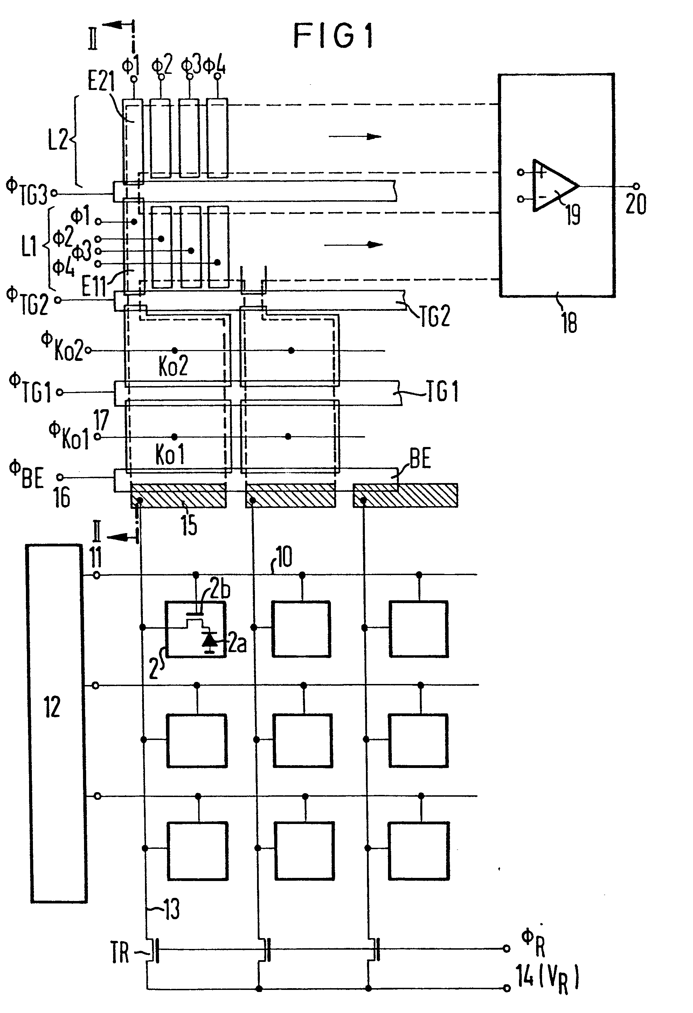

In Fig. 1 ist eine Schaltung dargestellt, bei der ein zweidimensionaler Bildsensor und die ihm zugeordneten Ausleseeinrichtungen auf einem dotierten Halbleiterkörper, z.B. aus p-leitendem Silizium, monolithisch integriert sind. Der Bildsensor weist aus Gründen einer einfachen Darstellung nur neun Sensorelemente auf, die in drei Zeilen und drei Spalten angeordnet sind. Im allgemeinen weisen Bildsensoren dieser Art jedoch 100 oder mehr Elemente pro Zeile und Spalte auf. Die Sensorelemente der ersten Zeile sind mit einer gemeinsamen Zeilenleitung 10 verbunden, die an einen Ausgang 11 eines digitalen Schieberegisters 12 geführt ist. Über den Ausgang 11 sind sämtliche Elemente der Zeile 10 gleichzeitig selektierbar. In analoger Weise sind auch die Sensorelemente der übrigen Zeilen über ihre Zeilenleitungen mit Ausgängen des Schieberegisters 12 verbunden, die den Zeilenleitungen individuell zugeordnet sind.

Für jede Sensorspalte ist eine Spaltenleitung, z.B. 13, vorgesehen, die mit allen Sensorelementen dieser Spalte verbindbar ist und über einen mit einer Taktimpulsspannung $\Phi R$ beschalteten Transistor TR mit einem Anschluss 14 in Verbindung steht, der auf einem Referenzpotential $V_R$

liegt. Die übrigen Spaltenleitungen sind ebenfalls mit den neben ihnen angeordneten Sensorelementen verbindbar und über eigene Transistoren an den Anschluss 14 geführt. Die Spaltenleitung 13 ist weiterhin mit einem an der Grenzfläche des Halbleiterkörpers 1 vorgesehenen Gebiet 15 verbunden, das eine zu diesem entgegengesetzte Leitfähigkeit aufweist. Der neben dem Gebiet 15 liegende Halbleiterbereich ist von einem Gate BE überdeckt, das über seinen Anschluss 16 mit einer Taktimpulsspannung $\Phi_{BE}$ beschaltet ist und durch eine dünne elektrisch isolierende Schicht, z.B. aus SiO$_2$, von der Grenzfläche des Halbleiterkörpers getrennt ist. Das Gate BE stellt ein Barriere-Element dar, wenn die Amplitude von $\Phi_{BE}$ so klein gewählt wird, dass ein niedriger Transferstrom eingestellt wird. Das Gate BE kann auch zusammen mit dem Gebiet 15 als ein Transistor aufgefasst werden, der durch die Amplitude von $\Phi_{BE}$ auf einen im Sättigungsbereich liegenden Arbeitspunkt eingestellt wird, der einen niedrigen Drainstrom bestimmt. In gleicher Weise sind auch die anderen Spaltenleitungen mit Halbleitergebieten 15'... verbunden, wobei das Gate BE auch neben diesen Gebieten angeordnet ist.

Die Sensorelemente 2 bestehen z.B. aus Fotodioden 2a, die jeweils über die Source-Drain-Strecke eines Feldeffekttransistors 2b mit der zugehörigen Spaltenleitung verbunden sind. Das Gate von 2b liegt dabei an der zugehörigen Zeilenleitung. Andererseits können die Sensorelemente 2 auch aus MIS-Kondensatoren bestehen oder als CID-Elemente ausgebildet sein, die jeweils zwei nebeneinanderliegende MIS-Kondensatoren aufweisen. Alle genannten Sensorelemente sind an sich bekannt, so z.B. aus P.G. Jespers et al. (Hrsg.), «Solid State Imaging», Noordhof Int. Publishing, Leyden, Niederlande und S. Ohba et al., «A 1024 Element Linear CCD Sensor with a new photodiode structure», Proc. IEDM 1977, Washington, Seiten 538–541. Werden Fotodioden verwendet, so ergibt sich der Vorteil einer gleichmässigen spektralen Empfindlichkeit.

An der von dem Gebiet 15 abgewandten Seite des Gate BE ist ein MIS-Kondensator Ko1 plaziert, dessen äussere Elektrode über einen Anschluss 17 mit einer Impulsspannung $\Phi_{Ko1}$ beschaltet ist. Es folgen ein Transfergate TG1, ein MIS-Kondensator Ko2 und ein Transfergate TG2, die jeweils mit den Impulsspannungen $\Phi_{TG1}$, $\Phi_{Ko2}$ und $\Phi_{TG2}$ beschaltet sind. Der Kondensator Ko2 ist über das Transfergate TG2 mit dem Halbleiterbereich unterhalb der ersten Transferelektrode E11 eines CTD-Schieberegisters (Charge Transfer Device) L1 verbunden. Die aus den ersten vier Elektroden bestehende Stufe des im 4-Phasen-Betrieb arbeitenden Schieberegisters L1 ist der Spaltenleitung 13 zugeordnet. Den anderen Spaltenleitungen sind jeweils entsprechende Serienschaltungen zweier MIS-Kondensatoren und zweier Transfergates sowie jeweils eine Stufe des Schieberegisters L1 zugeordnet.

Neben dem Schieberegister L1 ist ein zweites CTD-Schieberegister L2 angeordnet, das von L1 durch ein Transfergate TG3 getrennt ist. Unterhalb der verlängerten Elektroden der Schieberegister kann eine Ladungsübertragung zwischen L1 und L2 stattfinden, wenn ein Taktimpuls $\Phi_{TG3}$ angelegt wird. Die Transferelektroden von L2 sind ebenso wie die von L1 mit Taktimpulsspannungen $\Phi 1$ bis $\Phi 4$ beschaltet. Die Ausgangsstufen von L1 und L2 sind im einzelnen nicht dargestellt, sondern nach Fig. 1 in einem Block 18 enthalten, der eine differenzbildende Schaltung 19, z.B. einen Differenzverstärker, aufweist. Der Ausgang der differenzbildenden Schaltung 19 stellt den Schaltungsausgang 20 dar.

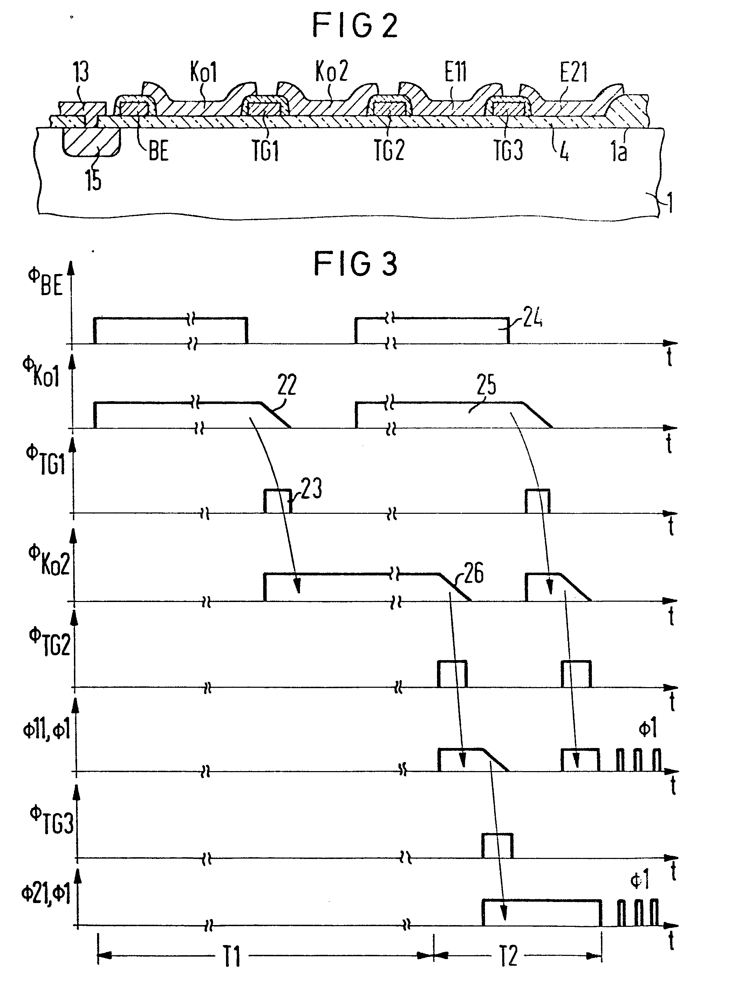

Fig. 2 zeigt einen Querschnitt durch die Schaltung nach Fig. 1 entlang der Linie II–II. Wie hieraus hervorgeht, sind die Schaltungsteile 13, BE, Ko1, TG1, Ko2, TG2, E11, TG3 und E21 auf der bereits erwähnten, den Halbleiterkörper abdeckenden isolierenden Schicht 4 aufgebracht und durch Zwischenisolierungen voneinander getrennt.

Um die Sensorelemente einer Zeile auszulesen, werden sie über die leitend geschalteten Transistoren 2b und TR auf das Referenzpotential $V_R$ zurückgesetzt. Anschliessend werden die Transistoren TR wieder gesperrt, so dass die Spaltenleitungen und die Fotodioden von äusseren Potentialen freigeschaltet sind («floating»-Zustand). In den Fotodioden optisch generierte Ladungsträger senken nun das Potential der Spaltenleitungen solange ab, bis die Transistoren 2b gesperrt werden. Die Zeitspanne zwischen dem Sperren der Transistoren TR und dem Sperren von 2b wird als Integrationszeit bezeichnet. Die am Ende der Integrationszeit erreichte Potentialabsenkung wird auf die Spaltenleitung übertragen und somit auch dem Gebiet 15 mitgeteilt. Das bewirkt einen Ladungstransport aus dem Gebiet 15 über die Potentialbarriere unterhalb von BE in den Speicherkondensator Ko1, der hierbei mit der Spannung $\Phi_{Ko1}$ beschaltet ist. Beim Auftreten der Flanke 22 von $\Phi_{Ko1}$ und eines Taktimpulses 22 von $\Phi_{TG2}$ wird die in Ko1 gespeicherte Ladung auf Ko2 übertragen, der hierbei an der Spannung $\Phi_{Ko2}$ liegt.

Nach dieser Ladungsübertragung erfolgt ein zweiter Auslesevorgang an denselben Fotodioden, die zu diesem Zweck wieder auf das Potential $V_R$ rückgesetzt werden. Die auf den Spaltenleitungen entstehenden Potentialabsenkungen entsprechen hierbei wegen der nunmehr wesentlich kleineren Integrationszeit den bereits genannten Nullsignalen, die aus den sensoreigenen Störsignalen bestehen. Diese Nullsignale hatten sich beim ersten Auslesevorgang den Sensorsignalen überlagert. Die Nullsignale werden beim Auftreten eines zweiten Taktimpulses $\Phi_{BE}$, der in Fig. 3 mit 24 bezeichnet ist, in den Kondensator Ko1 übertragen, wobei diesem ein Taktimpuls 25 zugeführt wird. Durch die Flanke 26 von $\Phi_{Ko2}$ und durch den Taktimpuls $\Phi_{TG2}$ wird die zuerst ausgelesene Signalladung unter die Transferelektrode E11 von L1 transportiert, die auf einer Spannung $\Phi_{11}$ liegt. Durch die Flanke 27 von $\Phi_{11}$ und einen Taktimpuls $\Phi_{TG3}$ gelangt sie schliesslich unter die Transferelektrode E21 von L2, die an einer Spannung $\Phi_{21}$ liegt. Die Flanke 28 von $\Phi_{Ko1}$ bewirkt nun zusam-

men mit einem Taktimpuls $\Phi_{TG1}$ die Übertragung der Nullsignalladung auf Ko2 und die Flanke 29 zusammen mit einem Taktimpuls $\Phi_{TG2}$ die weitere Übertragung dieser Ladung aus Ko2 in den Halbleiterbereich unter der auf $\Phi_{11}$ liegenden Elektrode E11.

Es folgt eine Auslesung der unterhalb von E21 und E11 gespeicherten Ladungen und der in den übrigen Stufen von L1 und L2 gespeicherten, entsprechenden Ladungen, die von anderen Spaltenleitungen herrühren, mittels der Spannungen $\Phi1$ bis $\Phi4$, von denen in Fig. 3 jeweils nur die Taktimpulse $\Phi1$ angedeutet sind.

Der Zeitraum T2 (Fig. 3), in dem die Signalladung aus dem Kondensator Ko2 in das Gebiet unter E21 und die Nullsignalladung in das Gebiet unter E11 transportiert werden, kann z.B. aus der Austastlücke zwischen zwei Fernsehzeilen bestehen, die 12 µs beträgt. Der Zeitraum T1, der dann dem übrigen Teil der Fernsehzeile entspricht und somit 52 µs beträgt, reicht zur Abspeicherung der Sensorsignale in Ko2 aus. Die Speicherung der Nullsignale in Ko1 erfolgt teilweise in der Zeitspanne T2. Die Auslesung der Schieberegister L1 und L2 erfolgt nach der Zeitspanne T2 und kann bis zum Beginn der nächstfolgenden Zeitspanne T2 fortgesetzt werden. Da T1 wesentlich grösser ist als T2, kann eine relativ langsame Übertragung der Sensorsignalladungen über die Potentialbarriere von BE in den Speicherkondensator Ko1 erfolgen, so dass Übertragungsverluste weitgehend ausgeschaltet sind.

In der differenzbildenden Schaltung 19 werden aus den ankommenden Signalladungen und Nullsignalladungen Differenzsignale abgeleitet, die die entstörten Sensorsignale darstellen.

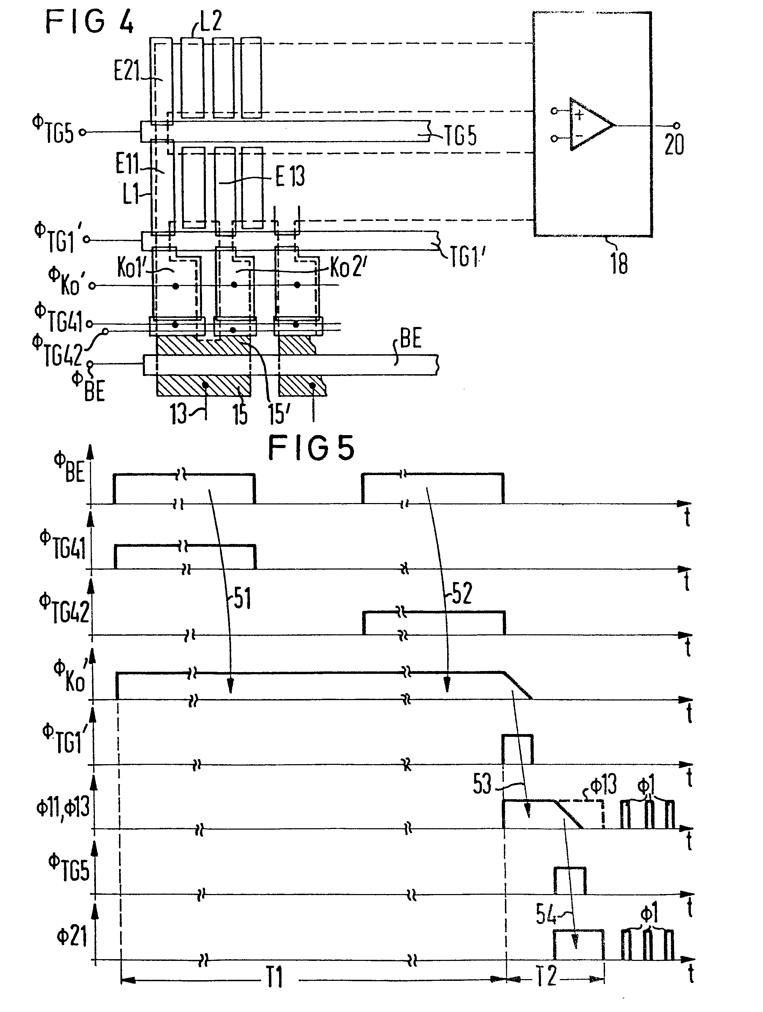

Bei der in Fig. 4 dargestellten Schaltung ist der Speicherkondensator Ko1' zwischen dem Gate BE und der Transferelektrode E11 von L1 vorgesehen und der Speicherkondensator Ko2' zwischen BE und der Transferelektrode E13, die zu der gleichen Stufe von L1 gehört wie E11. Zwischen den Speicherkondensatoren und dem Gate BE sind ein weiteres, entgegengesetzt zu 1 dotiertes Gebiet 15' und zwei Transfergates TG41 und TG42 vorgesehen, die jeweils neben den Speicherkondensatoren liegen. Ko1' und Ko2' sind über ein Transfergate TG1' mit zwei unterschiedlichen Eingängen E11 und E13 einer Transferstufe von L1 verbunden, während einander entsprechende Stufen der Schieberegister L1 und L2 über ein Transfergate TG5 miteinander verbunden sind, allerdings nur im Bereich eines der Eingänge jeder Stufe von L1.

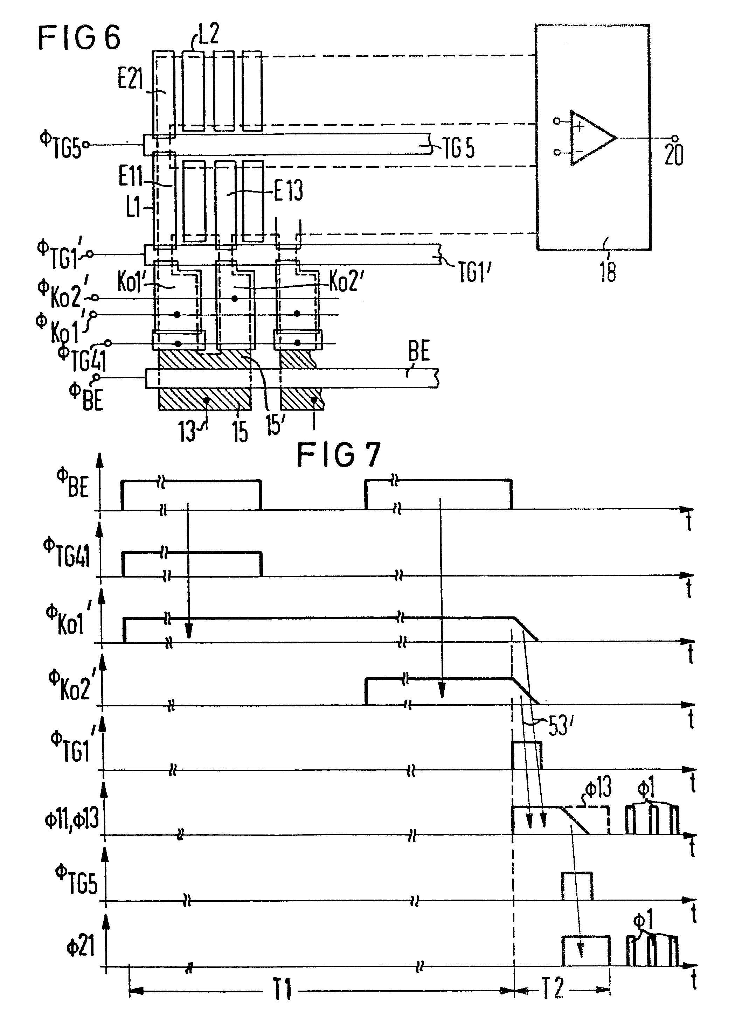

Die Transfergates TG41 und TG42 sind mit Taktimpulsspannungen $\Phi_{TG41}$ und $\Phi_{TG42}$ beschaltet, die Speicherkondensatoren Ko1 und Ko2 mit einer gemeinsamen Spannung $\Phi_{Ko}'$. Die Zeitabhängigkeit der verwendeten Spannungen ist in Fig. 5 dargestellt. Durch den Pfeil 51 ist eine Zwischenspeicherung der Signalladung im Kondensator Ko1 angedeutet, durch den Pfeil 52 eine Zwischenspeicherung der Nullsignalladung im Kondensator Ko2. Die Ladungen beider Kondensatoren werden gemeinsam, wie durch den Pfeil 53 angedeutet, unter die Transferelektroden E11 und E13 transportiert, wobei E11 an einer Impulsspannung $\Phi_{11}$ liegt, die in Fig. 3 durch eine ausgezogene Linie dargestellt ist, während E13 an einer Impulsspannung $\Phi_{13}$ liegt, die um den gestrichelt angedeuteten Teil länger ist als $\Phi_{11}$. Ein Pfeil 54 deutet einen Ladungstransport von E11 nach E21 an. Die in die Schieberegister eingelesenen Ladungen werden dann wieder schrittweise zur differenzbildenden Schaltung 19 hinverschoben, die aus der Signalladung und der Nullsignalladung ein Differenzsignal ableitet.

Die Schaltung nach Fig. 6 unterscheidet sich von Fig. 4 nur dadurch, dass die Ansteuerung der Kondensatoren Ko1' und Ko2' geändert ist. Hier ist das Transfergate TG42 weggelassen, wobei der Kondensator Ko2' bis an die Grenze des Gebiets 15' verlängert ist. Er ist mit einer Taktimpulsspannung $\Phi_{Ko2}'$ beschaltet, während an Ko1' eine Taktimpulsspannung $\Phi_{Ko1}$ liegt, die der Spannung $\Phi_{Ko}'$ von Fig. 4 entspricht. Der Funktionsablauf ist derselbe wie bei Fig. 4. In der Darstellung nach Fig. 7 sind jetzt zwei Pfeile 53' für den Ladungstransport aus den Kondensatoren unter die Elektroden E11 und E13 vorgesehen, die dem Pfeil 53 in Fig. 5 entsprechen.

Den Figuren 5 und 7 ist zu entnehmen, dass auch bei den Ausführungen nach den Figuren 4 und 6 kurze Zeitspannen T2 für die Ladungsübertragungen aus den Kondensatoren in die Schieberegister erreicht werden, während jeweils grosse Zeiträume T1 für die Zwischenspeicherung der Signale in den Speicherkondensatoren zur Verfügung stehen.

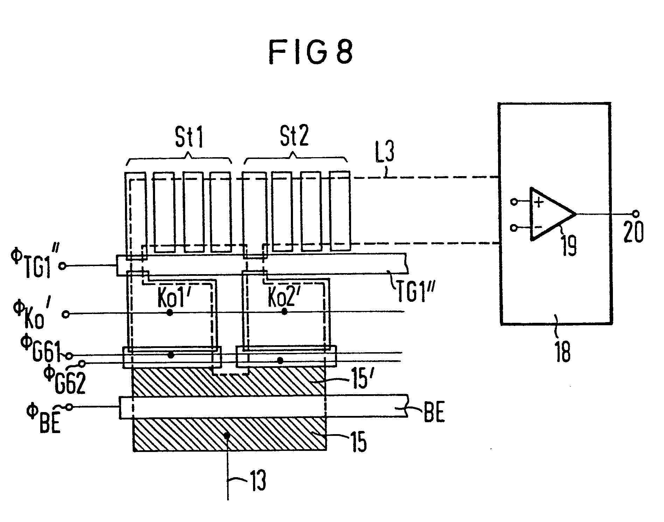

Fig. 8 unterscheidet sich von Fig. 4 dadurch, dass nur ein Schieberegister L3 vorgesehen ist. Zwei Stufen St1 und St2 desselben sind jeweils einer Spaltenleitung 13 zugeordnet. Die Transfergates TG61 und TG62 entsprechen den Gates TG41 und TG42 von Fig. 4, das Gate TG1'' entspricht TG1' von Fig. 4. Die Signalladungen und Nullsignalladungen werden jeweils alternierend auf die Stufen des Schieberegisters aufgeteilt und nacheinander dem Schaltungsteil 19 zugeführt, der die Differenzsignale ableitet.

## Patentansprüche

1. Integrierte Schaltung mit einem zweidimensionalen Halbleiter-Bildsensor, bei der die einzelnen Sensorelemente (2) in Zeilen und Spalten angeordnet sind, bei der Spaltenleitungen (13) vorgesehen sind, die mit einzelnen neben ihnen in ein und derselben Zeile liegenden Sensorelementen jeweils gleichzeitig verbindbar sind und bei der zwischen den Spaltenleitungen (13) und den Stufen eines ersten analogen Schieberegisters (L1) ein Barriere-Element (BE), erste Speicherkondensatoren (Ko1) und erste Transfergates (TG1) vorgesehen sind, dadurch gekennzeichnet, dass zweite Speicherkondensatoren (Ko2) vorgesehen sind, die den ersten Transfergates (TG1) in Spaltenrichtung nachgeordnet sind, dass die zweiten Speicherkondensatoren (Ko2) über zweite Transfergates (TG2) mit den Stufen des ersten analogen Schieberegisters (L1) in Serie geschaltet sind und dass ausser dem ersten (L1) ein zweites analoges Schieberegisters (L2) vorgesehen ist, dessen Stufen mit den entsprechenden Stufen des ersten Schieberegisters (L1) über dritte Transfergates (TG3) in Serie geschaltet sind (Fig. 1).

2. Integrierte Schaltung mit einem zweidimensionalen Halbleiter-Bildsensor, bei der die einzelnen Sensorelemente (2) in Zeilen und Spalten angeordnet sind, bei der Spaltenleitungen (13) vorgesehen sind, die mit einzelnen neben ihnen in ein und derselben Zeile liegenden Sensorelementen jeweils gleichzeitig verbindbar sind und bei der zwischen den Spaltenleitungen (13) und den Stufen eines ersten analogen Schieberegisters (L1) ein Barriere-Element (BE), erste Speicherkondensatoren (Ko1') und erste Transfergates (TG1') vorgesehen sind, dadurch gekennzeichnet, dass das Barriere-Element (BE) im Bereich jeder Spaltenleitung (13) mit einem ersten (Ko1') und einem zweiten Speicherkondensator (Ko2') jeweils in Serie geschaltet ist, wobei zwischen dem Barriere-Element (BE) und dem ersten der beiden Speicherkondensatoren (Ko1') ein viertes Transfergate (TG41) angeordnet ist, dass die ersten und zweiten Speicherkondensatoren (Ko1', Ko2') über die ersten Transfergates (TG1') mit ersten und zweiten Eingängen der Stufen des ersten analogen Schieberegisters (L1) in Serie geschaltet sind und dass ausser dem ersten ein zweites analoges Schieberegister (L2) vorgesehen ist, dessen Stufen mit den entsprechenden Stufen des ersten Schieberegisters (L1) über fünfte Transfergates (TG5) in Serie geschaltet sind (Fig. 6).

3. Integrierte Schaltung mit einem zweidimensionalen Halbleiter-Bildsensor, bei der die einzelnen Sensorelemente (2) in Zeilen und Spalten angeordnet sind, bei der Spaltenleitungen (13) vorgesehen sind, die mit einzelnen neben ihnen in ein und derselben Zeile liegenden Sensorelementen jeweils gleichzeitig verbindbar sind und bei der zwischen den Spaltenleitungen (13) und den Stufen eines analogen Schieberegisters (L3) ein Barriere-Element (BE), erste Speicherkondensatoren (Ko1') und erste Transfergates (TG1'') vorgesehen sind, dadurch gekennzeichnet, dass das Barriere-Element (BE) im Bereich jeder Spaltenleitung (13) mit einem ersten (Ko1') und einem zweiten Speicherkondensator (Ko2') jeweils in Serie geschaltet ist, wobei zwischen dem Barriere-Element (BE) und dem ersten der beiden Speicherkondensatoren (Ko1') ein sechstes Transfergate (TG6) angeordnet ist und dass die ersten und zweiten Speicherkondensatoren (Ko1', Ko2') über die ersten Transfergates (TG1'') mit unterschiedlichen Stufen des analogen Schieberegisters (L3) in Serie geschaltet sind (Fig. 8).

4. Integrierte Schaltung nach einem der Ansprüche 2 oder 3, dadurch gekennzeichnet, dass zwischen dem Barriere-Element (BE) und dem anderen der beiden Speicherkondensatoren (Ko2') ein weiteres Transfergate angeordnet ist (Fig. 4, Fig. 8).

5. Schaltung nach einem der Ansprüche 1 bis 4, dadurch gekennzeichnet, dass die Sensorelemente (2) Fotodioden enthalten.

6. Schaltung nach einem der Ansprüche 1 bis 4, dadurch gekennzeichnet, dass die Sensorelemente (2) jeweils einen oder zwei nebeneinanderliegende MIS-Kondensatoren enthalten.

7. Schaltung nach einem der Ansprüche 1 bis 6, dadurch gekennzeichnet, dass das Barriere-Element aus einem Barriere-Transistor besteht, der über seinen Gateanschluss mit einer Konstantspannung beschaltet ist, die einen im Sättigungsbereich liegenden, einen niedrigen Drainstrom bestimmenden Arbeitspunkt definiert.

8. Schaltung nach einem der Ansprüche 1 bis 7, dadurch gekennzeichnet, dass sie als eine in MIS-Technik gefertigte, auf einem dotierten Halbleiterkörper monolithisch integrierte Schaltung ausgebildet ist.

9. Verfahren zum Betrieb einer Schaltung nach Anspruch 1, dadurch gekennzeichnet, dass zunächst die Signalladungen einer Sensorzeile über die ersten Speicherkondensatoren (Ko1) auf die zweiten Speicherkondensatoren (Ko2) übertragen werden, dass anschliessend die Nullsignalladungen derselben Sensorzeile auf die ersten Speicherkondensatoren (Ko1) übertragen werden, dass die Signalladungen aus den zweiten Speicherkondensatoren (Ko2) über die Transferstufen des ersten Schieberegisters (L1) auf die entsprechenden Transferstufen des zweiten Schieberegisters (L2) übertragen werden, dass die Nullsignalladungen aus den ersten Speicherkondensatoren (Ko1) über die zweiten Speicherkondensatoren (Ko2) auf die Stufen des ersten Schieberegisters (L1) übertragen werden und dass die aus beiden Schieberegistern ausgegebenen, von einer Sensorspalte abgeleiteten Signale jeweils einer Differenzbildung unterzogen werden.

10. Verfahren zum Betrieb einer Schaltung nach Anspruch 2, dadurch gekennzeichnet, dass zunächst die Signalladungen einer Sensorzeile auf die ersten Speicherkondensatoren (Ko1) übertragen werden, dass anschliessend die Nullsignalladungen derselben Sensorzeile auf die zweiten Speicherkondensatoren (Ko2') übertragen werden, dass die Signalladungen jeweils auf einen ersten Speicherplatz der Stufen des ersten Schieberegisters (L1) und die Nullsignalladungen jeweils auf einen zweiten Speicherplatz in denselben Stufen des ersten Schieberegisters (L1) übertragen werden, dass die Signalladungen dann auf die entsprechenden Stufen des zweiten Schieberegisters (L2) übertragen werden und dass die aus beiden Schieberegistern (L1, L2) ausgegebenen, von einer Sensorspalte abgeleiteten Signale jeweils einer Differenzbildung unterzogen werden.

11. Verfahren zum Betrieb einer Schaltung nach Anspruch 3, dadurch gekennzeichnet, dass die Signalladungen einer Sensorzeile auf die ersten Speicherkondensatoren (Ko1') übertragen werden, dass anschliessend die Nullsignalladungen derselben Sensorzeile auf die zweiten Speicherkondensatoren (Ko2') übertragen werden, dass die Signalladungen und die Nullsignalladungen auf unterschiedliche Stufen eines Schieberegisters (L3) übertragen werden und dass die aus diesem nacheinander ausgegebenen, von einer Sensorspalte abgeleiteten Signale jeweils einer Differenzbildung unterzogen werden.

**Claims**

1. An integrated circuit comprising a two-dimensional semiconductor image sensor, wherein the individual sensor elements (2) are arranged in rows and columns, wherein column lines (13) are provided which can in each case be simultaneously connected to individual sensor elements arranged beside them in one and the same row and wherein a barrier element (BE), first storage capacitors (Ko1) and first transfer gates (TG1) are arranged between the column lines (13) and the stages of a first analogue shift register (L1), characterised in that second storage capacitors (Ko2) are provided on that side of the first transfer gate (TG1) remote from the columns, that the second storage capacitors (Ko2) are connected in series to the stages of a first analogue shift register (L1) via second transfer gates (TG2), and that in addition to the first analogue shift register (L1) there is provided a second analogue shift register (L2), the stages of which are connected in series to the corresponding stages of the first shift register (L1) via third transfer gates (TG3) (Fig. 1).

2. An integrated circuit comprising a two-dimensional semiconductor image sensor, wherein the individual sensor elements (2) are arranged in rows and columns, wherein column lines (13) are provided, which can in each case be simultaneously connected to individual sensor elements arranged beside them in one and the same row and wherein a barrier element (BE), first storage capacitors (Ko1') and first transfer gates (TG1') are arranged between the column lines (13) and the stages of a first analogue shift register (L1), characterised in that in the region of each column line (13) the barrier element (BE) is connected in series to a first storage capacitor (Ko1') and a second storage capacitor (Ko2'), where a fourth transfer gate (TG41) is arranged between the barrier element (BE) and the first of the two storage capacitors (Ko1'), that the first and second storage capacitors (Ko1', Ko2') are connected in series via the first transfer gates (TG1') to first and second inputs of the stages of the first analogue shift register (L1) and that in addition to the first analogue shift register there is provided a second analogue shift register (L2), the stages of which are connected in series with the corresponding stages of the first shift register (L1) via fifth transfer gates (TG5) (Fig. 6).

3. An integrated circuit comprising a two-dimensional semiconductor image sensor, wherein the individual sensor elements (2) are arranged in rows and columns, wherein column lines (13) are provided which can in each case be simultaneously connected to individual sensor elements arranged beside them in one and the same row, and wherein a barrier element (BE), first storage capacitors (Ko1') and first transfer gates (TG1'') are arranged between the column lines (13) and the stages of an analogue shift register (L3), characterised in that in the region of each column line (13) the barrier element (BE) is connected in series to a first storage capacitor (Ko1') and a second storage capacitor (Ko2'), where a sixth transfer gate (TG6) is arranged between the barrier element (BE) and the first of the two storage capacitors (Ko1') and that the first and second storage capacitors (Ko1', Ko2') are connected in series via the first transfer gates (TG1'') to different stages of the analogue shift register (L3) (Fig. 8).

4. An integrated circuit as claimed in one of the Claims 2 or 3, characterised in that a further transfer gate is arranged between the barrier element (BE) and the other of the two storage capacitors (Ko2') (Fig. 4, Fig. 8).

5. A circuit as claimed in one of the Claims 1 to 4, characterised in that the sensor elements (2) contain photo-diodes.

6. A circuit as claimed in one of the Claims 1 to 4, characterised in that the sensor elements (2) in each case contain one or two juxtaposed MIS-capacitors.

7. A circuit as claimed in one of the Claims 1 to 6, characterised in that the barrier element consists of a barrier transistor connected via its gate terminal to a constant voltage which defines an operating point located in the saturation range and governs a low drain current.

8. A circuit as claimed in one of the Claims 1 to 7, characterised in that it is monolithically integrated on a doped semiconductor body and manufactured in MIS-technology.

9. A method of operating a circuit as claimed in Claim 1, characterised in that firstly the signal charges of a sensor row are transferred via the first storage capacitors (Ko1) to the second storage capacitors (Ko2), that the zero signal charges of the same sensor row are then transferred to the first storage capacitors (Ko1), that the signal charges from the second storage capacitors (Ko2) are transferred, via the transfer stages of the first shift register (L1), to the corresponding transfer stages of the second shift register (L2), that the zero signal charges from the first storage capacitors (Ko1) are transferred, via the second storage capacitors (Ko2), to the stages of the first shift register (L1) and that the signals which are emitted from the two shift registers and which are derived from a sensor column are in each case subjected to difference formation.

10. A method of operating a circuit as claimed in Claim 2, characterised in that firstly the signal charges of a sensor row are transferred to the first storage capacitors (Ko1'), that the zero signal charges of the same sensor row are then transferred to the second storage capacitors (Ko2'), that the signal charges are each transferred to a first storage position of the stages of the first shift register (L1) and the zero signal charges are each transferred to a second storage position in the same stages of the first shift register (L1), that the signal charges are then transferred to the corresponding stages of the second shift register (L2) and that the signals emitted from the two shift registers (L1, L2) and which are derived from one sensor column are in each case subjected to difference formation.

11. A method of operating a circuit as claimed in Claim 3, characterised in that the signal charges of a sensor row are transferred to the first storage capacitors (Ko1'), that the zero signal charges of the same sensor row are then transferred to the second storage capacitors (Ko2'), that the signal charges and the zero signal charges are transferred to different stages of a shift register (L3) and that the signals consecutively emitted from said shift register and are derived from one sensor column are in each case subjected to difference formation.

**Revendications**

1. Circuit intégré comportant un capteur d'image bidimensionnel à semi-conducteurs, dans lequel les différents éléments capteurs (2) sont disposés en lignes et en colonnes, dans lequel sont prévues des connexions de colonnes (13) qui peuvent chacune être reliées simultanément à différents éléments capteurs situés à côté d'elles dans une seule et même ligne et dans lequel un élément barrière (BE), des premiers condensateurs de mémorisation (Ko1) et des premières portes de transfert (TG1) sont prévus entre les connexions de colonnes (13) et les étages d'un premier registre à décalage analogique (L1), caractérisé en ce que des deuxièmes condensateurs de mémorisation (Ko2) sont prévus à la suite des premières portes de transfert (TG1), dans le sens des colonnes, que les deuxièmes condensateurs de mémorisation (Ko2) sont montés en série, à travers des deuxièmes portes de transfert (TG2), avec les étages du premier registre à décalage (L1) analogique et que, outre le premier (L1), il est prévu un second registre à décalage analogique (L2) dont les étages sont montés en série avec les étages correspondants du premier registre à décalage (L1) à travers des troisièmes portes de transfert (TG3) (Fig. 1).

2. Circuit intégré comportant un capteur d'image bidimensionnel à semi-conducteurs, dans lequel les différents éléments capteurs (2) sont disposés en lignes et en colonnes, dans lequel sont prévues des connexions de colonnes (13) qui peuvent chacune être reliées simultanément à différents éléments capteurs situés à côté d'elles dans une seule et même ligne et dans lequel un élément barrière (BE), des premiers condensateurs de mémorisation (Ko1') et des premières portes de transfert (TG1') sont prévus entre les connexions de colonnes (13) et les étages d'un premier registre à décalage analogique (L1), caractérisé en ce que l'élément barrière (BE) est monté chaque fois en série avec un premier (Ko1') et un deuxième condensateur de mémorisation (Ko2'), dans la région de chaque connexion de colonne (13), et une quatrième porte de transfert (TG41) est placée entre l'élément barrière (BE) et le premier des deux condensateurs de mémorisation (Ko1'), que les premiers et deuxièmes condensateurs de mémorisation (Ko1', Ko2') sont montés en série, à travers les premières portes de transfert (TG1'), avec des premières et deuxièmes entrées des étages du premier registre à décalage analogique (L1) et que, outre le premier, il est prévu un second registre à décalage analogique (L2) dont les étages sont montés en série avec les étages correspondants du premier registre à décalage (L1) à travers des cinquièmes portes de transfert (TG5) (Fig. 6).

3. Circuit intégré comportant un capteur d'image bidimensionnel à semi-conducteurs, dans lequel les différents éléments capteurs (2) sont disposés en lignes et en colonnes, dans lequel sont prévues des connexions de colonnes (13) qui peuvent chacune être reliées simultanément à différents éléments capteurs situés à côté d'elles dans une seule et même ligne et dans lequel un élément barrière (BE), des premiers condensateurs de mémorisation (Ko1') et des premières portes de transfert (TG1'') sont prévus entre les connexions de colonnes (13) et les étages d'un premier registre à décalage analogique (L1), caractérisé en ce que l'élément barrière (BE) est monté chaque fois en série avec un premier (Ko1') et un deuxième condensateur de mémorisation (Ko2'), dans la région de chaque connexion de colonne (13), et une sixième porte de transfert (TG6) est placée entre l'élément barrière (BE) et le premier des deux condensateurs de mémorisation (Ko1') et que les premiers et deuxièmes condensateurs de mémorisation (Ko1', Ko2') sont montés en série avec des étages différents du registre à décalage analogique (L3) à travers les premières portes de transfert (TG1'') (Fig. 8).

4. Circuit intégré selon la revendication 2 ou 3, caractérisé en ce qu'une porte de transfert supplémentaire est disposée entre l'élément barrière (BE) et l'autre des deux condensateurs de mémorisation (Ko2') (Fig. 4, Fig. 8).

5. Circuit selon une des revendications 1 à 4, caractérisé en ce que les éléments capteurs (2) contiennent des photodiodes.

6. Circuit selon une des revendications 1 à 4, caractérisé en ce que les éléments capteurs (2) contiennent chacun un ou deux condensateurs MIS placés l'un à côté de l'autre.

7. Circuit selon une des revendications 1 à 6, caractérisé en ce que l'élément barrière est formé d'un transistor barrière qui est soumis par sa borne de grille à une tension constante qui définit un point de fonctionnement, situé dans la zone de saturation, déterminant un faible courant de drain.

8. Circuit selon une des revendications 1 à 6, caractérisé en ce qu'il est réalisé comme un circuit intégré monolithique fabriqué selon la technique MIS sur un substrat semi-conducteur dopé.

9. Procédé pour le fonctionnement d'un circuit selon la revendication 1, caractérisé en ce que, tout d'abord, les charges de signaux d'une ligne du capteur sont transférées à travers les premiers condensateurs de mémorisation (Ko1) aux deuxièmes condensateurs de mémorisation (Ko2), que les charges de signaux zéro de la même ligne du capteur sont ensuite transférées aux premiers condensateurs de mémorisation (Ko1), que les charges de signaux sont transférées depuis les deuxièmes condensateurs de mémorisation (Ko2), à travers les étages de transfert du premier registre à décalage (L1), aux étages de transfert correspondants du second registre à décalage (L2), que les charges de signaux zéro sont transférées depuis les premiers condensateurs de mémorisation (Ko1), à travers les deuxièmes condensateurs de mémorisation (Ko2), aux étages du premier registre à décalage (L1) et que les signaux délivrés à la sortie des deux registres à décalage et tirés d'une colonne du capteur, sont soumis à une formation de différence.

10. Procédé pour le fonctionnement d'un circuit selon la revendication 2, caractérisé en ce que, tout d'abord, les charges de signaux d'une ligne du capteur sont transférées aux premiers condensateurs de mémorisation (Ko1'), que les charges de signaux zéro de la même ligne du capteur sont ensuite transmises aux deuxièmes condensateurs de mémorisation (Ko2'), que les charges de signaux sont transférées chacune à un premier emplacement de mémoire des étages du premier registre à décalage (L1) et les charges de signaux zéro sont transmis chacune à un deuxième emplacement de mémoire dans les mêmes étages du premier registre à décalage (L1), que les charges de signaux sont transmises ensuite aux étages correspondants du second registre à décalage (L2) et que les signaux délivrés par les sorties des deux registres à décalage (L1, L2) et tirés d'une colonne du capteur, sont soumis à une formation de différence.

11. Procédé pour le fonctionnement d'un circuit selon la revendication 3, caractérisé en ce que les charges de signaux d'une ligne du capteur sont transférées aux premiers condensateurs de mémorisation (Ko1'), que les charges de signaux zéro de la même ligne du capteur sont ensuite transférées aux deuxièmes condensateurs de mémorisation (Ko2'), que les charges de signaux et les charges de signaux zéro sont transférées à des étages différents d'un registre à décalage (L3) et que les signaux délivrés l'un après l'autre par la sortie de ce registre et tirés d'une colonne du capteur, sont soumis à une formation de différence.

# FIG 1

# F I G 2

# F I G 3

FIG 4

FIG 5

13

# FIG 6

# FIG 7

# FIG 8

St1　　St2　　L3

$\Phi_{TG1}''$

TG1''

$\Phi_{Ko}'$

Ko1'　　Ko2'

$\Phi_{G61}$

$\Phi_{G62}$

15'

$\Phi_{BE}$

BE

15

13

18

19

20